# DEMANDE DE BREVET EUROPEEN

(11) **EP 0 660 524 A1**
(43) Date de publication de la demande: **28.06.1995**
(21) Numéro de dépôt: 94402984.2
(22) Date de dépôt: 22.12.1994
(51) Int. Cl.: H03K 19/21, H03K 19/094

(54) **Porte logique OU-Exclusif intégrée**

(30) Priorité: 24.12.1993 FR 9315632
(71) Demandeur: BULL S.A., F-78430 Louveciennes (FR)
(72) Inventeur: Paindaveine, Yves, B-1440 Braine le Chateau (BE); Bernstein, Pierre, F-14480 Banville (FR); Bedouani, Mohamed, F-78220 Viroflay (FR)
(74) Mandataire: Denis, Hervé

(57) **Abrégé**

La porte logique OU-Exclusif (10a) ou la porte complémentaire (10b) à deux entrées binaires (a, b) comprend un circuit (11a, 11b) à trois niveaux logiques pour la formation des impliquants premiers (K, L; K', L') d'une fonction de type OU-Exclusif et un circuit de type OR (12a, 12b) pour faire la somme logique des impliquants premiers en considérant le niveau intermédiaire comme l'un des deux autres niveaux. L'invention s'applique notamment en logique SCFL dans l'arséniure de gallium ou en logique ECL dans le silicium monocristallin.

## Description

### Domaine technique.

L'invention se rapporte aux portes logiques de type OU-Exclusif, effectuant la fonction logique OU-Exclusif ou la fonction inverse NON-OU-Exclusif et appelées couramment portes de type XOR (XOR ou NXOR), intégrées dans un semi-conducteur. Elle s'applique plus particulièrement aux portes XOR à vitesse de commutation rapide, par exemple supérieure à 1 gigabit par seconde, telles que celles intégrées dans un semi-conducteur III-V tel que l'arséniure de gallium (AsGa). Dans cette application, la porte XOR conforme à l'invention peut être faite de transistors à effet de champ, surtout ceux de type MESFET (Metal-Semiconductor Field-Effect Transistor) et convient alors plus particulièrement à la logique SCFL (Source-Coupled FET Logic). Elle peut aussi être faite de transistors bipolaires intégrés dans l'arséniure de gallium ou dans du silicium monocristallin, par exemple en logique ECL (Emitter-Coupled Logic).

### L'art antérieur.

On sait que la fonction XOR de deux entrées logiques a et b est la somme des deux impliquants premiers ab* et a*.b, où a* et b* sont les compléments de a et b (a ⊕ b = a*b ∨ ab*). La porte XOR à deux entrées couramment utilisée forme un circuit à deux étages d'amplificateurs différentiels superposés entre deux potentiels d'alimentation, ordinairement désignés par exemple par Vdd et Vss en technologie à transistors à effet de champ. Dans chaque amplificateur différentiel, les transistors sont du même type (à déplétion ou à enrichissement) et forment une paire différentielle et symétrique pour fonctionner alternativement. Dans la porte XOR à deux étages, les transistors de l'amplificateur différentiel inférieur ont leurs sources alimentées par une source de courant constant connectée à un premier potentiel d'alimentation (Vss). Leurs grilles reçoivent les deux signaux complémentaires de l'entrée a et leurs drains ont chacun pour charge l'étage supérieur. L'étage supérieur comprend deux amplificateurs différentiels recevant chacun les signaux complémentaires de l'autre entrée b, et deux résistances de charge. Les paires de transistors symétriques constituant les deux amplificateurs différentiels ont leurs sources connectées aux drains respectifs des deux transistors de l'étage inférieur et leurs grilles reçoivent les signaux respectifs complémentaires b, b*. L'un des transistors de l'un des deux amplificateurs différentiels et le transistor symétrique de l'autre amplificateur différentiel ont leurs drains réunis et reliés au second potentiel d'alimentation (Vdd) par l'intermédiaire de l'une des résistances de charge. Les deux résistances de charge fournissent ainsi les deux tensions complémentaires représentatives de la fonction de type XOR (XOR et NXOR) des deux entrées a et b. Ces deux tensions sont appliquées à deux étages suiveurs pour délivrer les signaux de sortie. A ce sujet, la fonction NXOR de deux entrées logiques a et b est la somme logique des deux impliquants premiers ab et a*b* et s'écrit (a ⊕ b)* = ab ∨ a*b*.

Cette porte XOR offre l'avantage d'être très compacte. Cependant, les temps de propagation des signaux entre les bornes d'entrée et les bornes de sortie sont très différents selon que les signaux d'entrée sont a, a* ou b, b*. Les signaux a, a* traversent les transistors respectifs de l'étage inférieur et ceux de l'étage supérieur, tandis que les signaux b, b* ne traversent que les transistors respectifs de l'étage supérieur. Si cette porte est appliquée dans un système à logique asynchrone, elle convient bien aux circuits les plus lents, par exemple dans une horloge connectée à la sortie la plus lente du système. Mais en logique asynchrone la différence entre les temps de propagation se répercute sur les circuits qui suivent et altère le fonctionnement du système.

### L'invention.

L'invention remédie à ces inconvénients, en assurant des temps de propagation courts et équilibrés à une porte XOR convenant aussi bien aux portes intégrées dans un semi-conducteur III-V que dans le silicium monocristallin.

L'invention a pour objet une porte logique de type OU-Exclusif à deux entrées binaires (a, b), caractérisée en ce qu'elle comprend un circuit à trois niveaux logiques pour la formation des impliquants premiers d'une fonction de type OU-Exclusif et un circuit de type OR pour faire la somme logique des impliquants premiers en considérant le niveau intermédiaire comme l'un des deux autres niveaux.

L'invention a aussi pour objet corollaire un circuit intégré incluant la porte définie précédemment.

L'invention ressort de la description qui suit, donnée à titre d'exemple et faite en référence aux dessins annexés.

Dans les dessins :
- la figure 1 illustre schématiquement la structure d'une porte XOR et d'une porte NXOR conformes à l'invention, faites de transistors à effet de champ de type MESFET;
- la figure 2 est une table de vérité des portes XOR et NXOR représentées sur la figure 1, si elles avaient mis en oeuvre deux états logiques ;
- la figure 3 est la table de vérité conforme à l'invention des portes XOR et NXOR représentées sur la figure 1 ;
- la figure 4 illustre schématiquement la structure d'une porte XOR et d'une porte NXOR conformes à l'invention, faites de transistors bipolaires ; et
- la figure 5 est une table indiquant les niveaux de potentiel obtenus dans les portes représentées sur la figure 4.

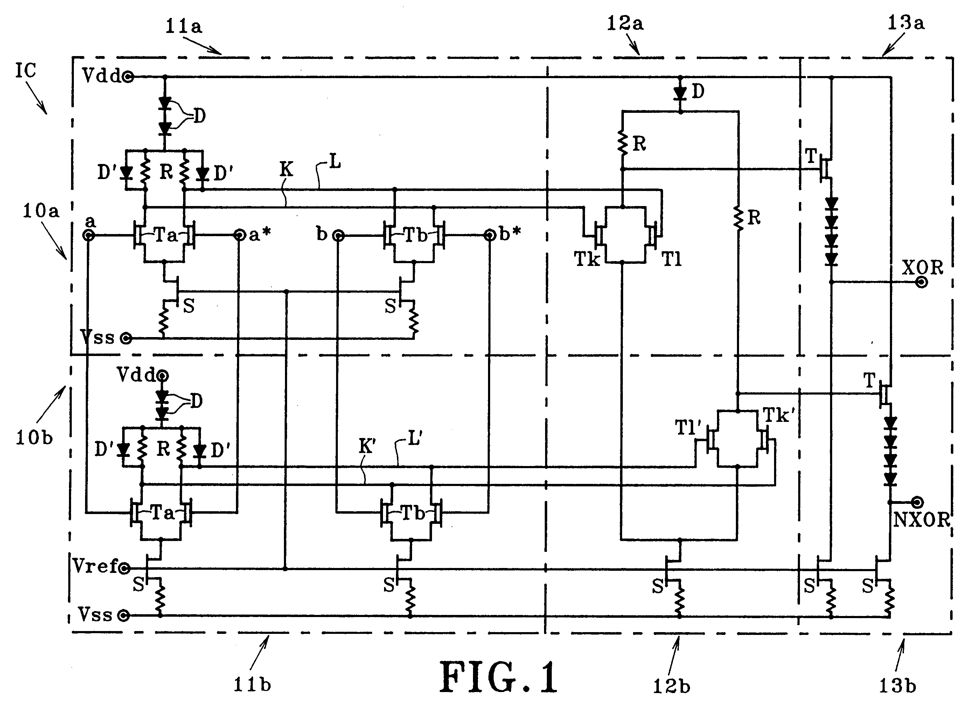

La figure 1 illustre un exemple de réalisation d'une porte logique XOR 10a et d'une porte NXOR 10b conformes à l'invention, intégrées dans l'arséniure de gallium d'un circuit intégré IC et faites en logique SCFL utilisant des transistors à effet de champ de type MESFET. Les portes 10a et 10b reçoivent deux entrées binaires a et b. Dans l'exemple illustré, elles reçoivent aussi les versions complémentaires a* et b* des deux entrées a et b. Les portes illustrées 10a et 10b comprennent respectivement deux circuits 11a et 11b générateurs d'impliquants premiers, deux portes de type OU 12a et 12b et deux étages de sortie 13a et 13b. Le circuit 11a est générateur des deux impliquants premiers de la fonction XOR, à savoir ab* et a*b, tandis que le circuit 11b est générateur des deux impliquants premiers ab et a*b* de la fonction complémentaire NXOR.

Dans l'exemple de la figure 1, les portes 10a et 10b reçoivent deux potentiels d'alimentation Vdd et Vss. Les circuits 11a et 11b comprennent chacun deux amplificateurs différentiels faits chacun d'un couple de transistors de même type, à déplétion dans l'exemple illustré, et symétriques pour fonctionner alternativement. Le premier amplificateur différentiel est fait de deux transistors Ta, dont les grilles reçoivent les versions complémentaires de l'entrée a, les drains sont connectés à deux résistances de charge respectives R et les sources sont connectées au drain d'un transistor S de type à enrichissement et servant de source de courant. Les résistances de charge R sont connectées au potentiel Vdd par l'intermédiaire de deux diodes de décalage de niveau D et sont montées en parallèle avec deux diodes de blocage respectives D' permettant d'obtenir la tension désirée sur les drains des transistors complémentaires. Le second amplificateur différentiel comprend aussi un couple de transistors symétriques Tb du même type, à déplétion dans l'exemple choisi, dont les grilles reçoivent les versions complémentaires de l'entrée b et les sources sont connectées au drain d'un transistor S servant de source de courant et du type à enrichissement dans l'exemple illustré. Dans les deux amplificateurs Ta et Tb, le drain du transistor recevant l'entrée a est connecté au drain du transistor recevant l'entrée b* pour produire un potentiel K représentatif de l'impliquant premier ab*, tandis que les drains des deux autres transistors sont interconnectés pour produire un potentiel L représentatif de l'impliquant premier a*b. Le circuit 11a fonctionne ainsi comme deux portes de type AND produisant les deux impliquants premiers respectifs. Les transistors S ont leurs grilles connectés à un potentiel de référence Vref et leurs sources reliées par des résistances respectives au potentiel d'alimentation Vss. Les transistors S constituent ainsi des sources de courant constant. Le circuit 11b de la porte 10b a la même structure que celle du circuit 11a, mais les drains des transistors recevant les signaux a et b sont interconnectés pour produire un potentiel K' représentatif de l'impliquant premier ab tandis que les drains des deux autres transistors sont interconnectés pour produire un potentiel L' représentatif de l'impliquant premier a*b*.

Les portes de type OR 12a et 12b sont en l'occurrence des portes NOR faites d'un amplificateur différentiel dont les deux branches incorporent respectivement deux couples de transistors à déplétion Tk, Tl et Tk', Tl' ayant leurs drains connectés à une résistance de charge R et leurs sources connectées au drain d'un transistor S servant de source de courant. Dans la porte 12a, les grilles des deux transistors Tk et Tl d'une branche reçoivent les potentiels respectifs K et L représentatifs des impliquants premiers produits par le circuit 11a, tandis que dans la porte 12b les grilles des deux transistors Tk' et Tl' de l'autre branche reçoivent les potentiels respectifs K' et L' représentatifs des impliquants premiers produits par le circuit 11b. Les résistances de charge R sont reliées, d'un côté, par une diode de décalage D au potentiel d'alimentation Vdd et, de l'autre côté, aux deux étages de sortie respectifs 13a et 13b constitués par des étages suiveurs. Chaque étage suiveur illustré 13 comprend de manière classique un transistor à déplétion T ayant une grille connectée à une résistance de charge R du circuit OR 12, un drain appliqué au potentiel d'alimentation Vdd, et une source reliée, par l'intermédiaire d'au moins une diode, en l'occurrence quatre diodes montées en série, à une borne de sortie et au drain d'un transistor S. A cause des portes NAND constituant les circuits 11a et 11b et des portes NOR 12a et 12b, les sorties respectives des étages suiveurs 13a et 13b délivrent des signaux représentatifs des fonctions XOR et NXOR. Les transistors S des portes de type OR 12 et des étages suiveurs 13 sont connectés de la même manière que celle des transistors S dans les circuits 11a et 11b. Dans l'exemple illustré, l'emploi des diodes D et D' est déterminé de façon à avoir des entrées-sorties compatibles avec d'autres circuits similaires.

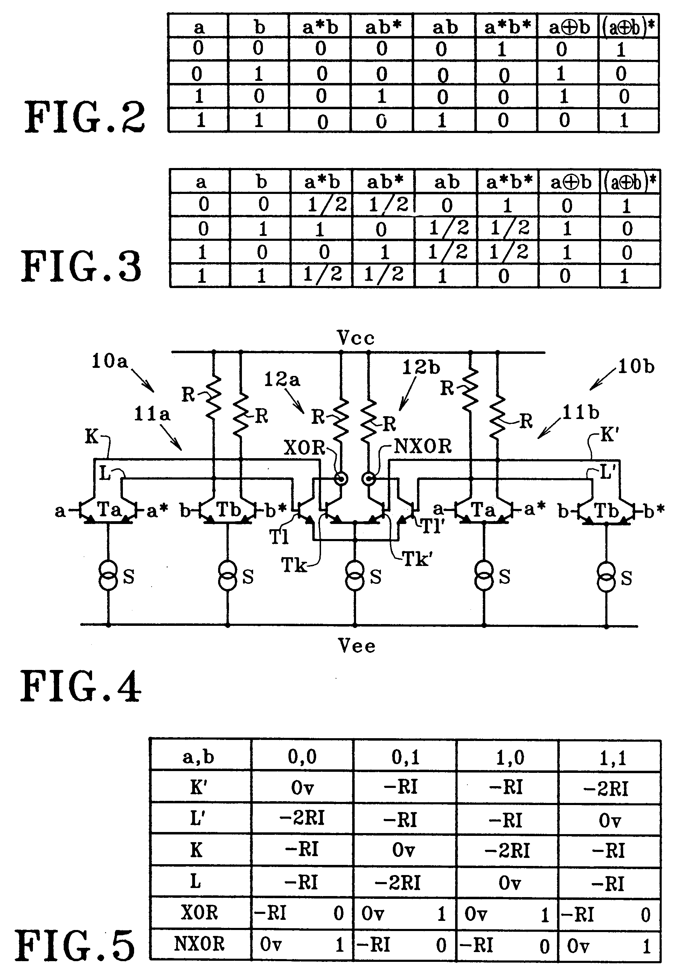

La figure 2 représente la table de vérité de la porte XOR 10a et de la porte NXOR 10b de la figure 1, faites de manière classique dans une technologie à deux niveaux de potentiel nommés 0 et 1. La figure 2 illustre le non recouvrement des impliquants premiers.

La figure 3 représente la table de vérité de la porte XOR 10a et de la porte NXOR 10b conformes à l'invention. L'invention fait intervenir une logique à trois niveaux, dont le niveau intermédiaire est représenté par le nombre 1/2. Plus précisément, on voit sur la figure 3 que le niveau intermédiaire du circuit 11a correspond à l'égalité des entrées a et b, et que le niveau intermédiaire du circuit 11b correspond à l'inégalité des entrées a et b. Il en résulte, comme cela ressort de la figure 3, que chaque transition de a ou b entre les niveaux binaires 0 et 1 produit à la sortie des circuits 11a et 11b des transitions égales à 1/2. Sachant que les transitions de valeur 1 entre les niveaux 0 et 1 sont plus longues que les transitions de valeur 1/2, la table de vérité représentée sur la figure 3 assure à la fois des temps de propagation courts et égaux.

Dans l'exemple illustré, la production des trois niveaux logiques par chacun des circuits 11a et 11b est faite dans les conditions suivantes. Les quatre transistors Ta et Tb des circuits 11a et 11b sont montés en source commune, de sorte que chaque transistor tire un courant I/2 quand il est conducteur. Seulement deux signaux d'entrée sont au niveau logique haut en même temps. Quand les courants I/2 s'additionnent dans une résistance de charge R, la sortie est au niveau bas 0 et la sortie complémentaire est au niveau 1, et quand un courant I/2 passe dans chaque résistance de charge R, les deux sorties sont au niveau intermédiaire 1/2.

Les portes de type OR 12a et 12b sont alors conçues de façon à considérer le niveau logique intermédiaire 1/2 comme niveau 0 qui, dans l'exemple illustré, correspond à l'état bloqué des transistors des deux portes NOR 12 en réponse aux niveaux 0 et 1/2. On considère alors dans la table de vérité de la figure 3 le niveau intermédiaire 1/2 comme niveau 0. La table de vérité de la figure 3 est donc assimilée à celle de la figure 2. Le niveau 0 correspond alors à un état de conduction super bloqué. Dans l'exemple illustré, la détermination des niveaux logiques est faite en connectant une diode de blocage D' en parallèle avec chacune des résistances de charge R afin d'imposer une chute de tension suffisante pour considérer le niveau intermédiaire 1/2 comme le niveau 0, et le niveau intermédiaire est considéré comme le niveau 0 quand l'écart entre les deux niveaux est compris dans la marge tolérable de bruit. D'autre part, dans les deux portes NOR 12a et 12b illustrées, les quatre transistors à sources couplées utilisent ici une commutation en courant. Par conséquent, en considérant le niveau intermédiaire comme niveau 0, seulement deux des quatre transistors changent d'état en réponse à chacune des transitions correspondant aux quatre impliquants premiers. Les deux autres transistors restent bloqués et n'influencent donc pas la commutation.

Dans l'exemple illustré, les deux circuits 11a et 11b sont faits de deux portes de type AND (AND ou NAND) recevant respectivement les deux entrées avec leurs deux versions complémentaires. Cependant, d'autres structures connues que des portes de type AND peuvent constituer les circuits 11a et 11b. De plus, le circuit 11a peut avoir une structure différente de celle du circuit 11b, de même que les sorties désirées de ces deux circuits peuvent être fournies par une seule structure connue. On connaît aussi des circuits ne recevant que les signaux a et b sans leurs versions complémentaires. En d'autres termes, des structures connues à deux niveaux peuvent être adaptées pour produire trois niveaux logiques. Dans ce cas, les conditions d'adaptation peuvent donc être différentes de celles décrites précédemment. De même, des structures à trois niveaux peuvent être directement utilisées comme dans le cas présent.

La figure 4 illustre deux exemples de structure d'une porte 10 du type OU-Exclusif faite en technologie bipolaire. Plus précisément, elle représente une porte XOR 10a et une porte NXOR 10b ayant des structures similaires à celles de la figure 1, faites de montages différentiels symétriques pour la formation des circuits 11a et 11b de chaque porte 10. L'exemple illustré présente un schéma en logique CML totalement symétrique. Un schéma en logique ECL peut être obtenu par simple adjonction d'étages décaleurs de tension formés par des montages à émetteurs suiveurs bien connus de l'homme du métier. La porte XOR 10a et la porte NXOR 10b de la figure 4 sont alimentées par deux potentiels d'alimentation Vcc et Vee et comprennent respectivement les deux circuits 11a et 11b faits chacun d'un montage différentiel de deux transistors bipolaires Ta recevant les signaux complémentaires de l'entrée a et d'un montage différentiel de deux transistors bipolaires Tb recevant les signaux complémentaires de l'autre entrée b. Les deux montages sont alimentés par des sources de courant respectives S connectées au potentiel bas d'alimentation Vee. Dans la cellule 11a illustrée, les deux transistors Ta et Tb recevant les entrées respectives a et b ont leurs collecteurs reliés au potentiel haut d'alimentation Vcc par l'intermédiaire d'une résistance de charge R. Il en est de même pour les transistors Ta et Tb recevant les entrées respectives a* et b*. Les deux potentiels K et L fournis par les résistances R sont représentatifs des produits logiques ab* et a*b et sont additionnés logiquement dans une porte de type OR 12 formée de deux transistors Tk et Tl ayant leurs trajets collecteur-émetteur en parallèle et connectés en série entre une résistance de charge R et une source de courant S. Le point commun des deux collecteurs des transistors Tk et Tl constitue la borne de sortie de la porte 10a et fournit le signal de sortie XOR. Dans le circuit 11b de la porte 10b, les collecteurs des transistors Ta et Tb sont interconnectés pour obtenir des potentiels K' et L' représentatifs des produits logiques ab et a*b*, qui sont additionnés logiquement dans une porte de type OR 12b semblable à celle de l'autre cellule et dont la source de courant S leur est commune. Le point commun des collecteurs des transistors Tk' et Tl' constitue la borne de sortie de la porte 10b fournissant le signal NXOR.

La figure 5 indique les niveaux de potentiel obtenus dans un mode de réalisation des portes 10a et 10b représentées sur la figure 4, dans laquelle Vcc = 0 volt (0v) et Vee = -5 volts, R désigne la valeur des résistances de charge et I l'intensité du courant traversant chacune des sources S. Dans les rangées relatives aux sorties XOR et NXOR, 0 et 1 désignent les niveaux logiques. On observera principalement que les potentiels représentatifs des produits K, L, K' et L' peuvent prendre les trois valeurs 0, -RI et -2RI et constituent donc une logique ternaire. Il est aussi possible, comme dans le cas de la figure 1, de faire correspondre sensiblement le niveau intermédiaire -RI avec le niveau représentatif de l'état bloqué, par exemple en dimensionnant les transistors de façon que l'écart entre les deux niveaux soit compris dans la marge tolérable de bruit. On a donc par principe le même temps de propagation dans les deux portes 10a et 10b, quelle que soit l'entrée qui commute, quel que soit le front en sortie et quelle que soit la porte. Les buts et avantages de la combinaison des deux portes complémentaires 10a et 10b sont décrits en détails dans une demande de brevet français du demandeur déposée le même jour que la présente demande. Les tables des figures 2, 3 et 5 font partie intégrante de la description.

Il est à noter que dans le silicium monocristallin ces portes à transistors bipolaires ne peuvent pas être en pratique transposées en transistors à effet de champ, qui produirait une excursion logique de sortie (swing) trop faible. Celle excursion pourrait être augmentée en accroissant celle du circuit générateur, mais cela ralentirait les temps de commutation et augmenterait la consommation énergétique de la porte.

D'une manière générale, l'invention a donc pour objet une porte logique de type XOR (OU-Exclusif ou sa version complémentaire) à deux entrées a et b, comprenant un circuit à trois niveaux logiques pour la formation des impliquants premiers d'une fonction de type OU-Exclusif et un circuit de type OR pour faire la somme logique des impliquants premiers en considérant le niveau intermédiaire comme l'un des deux autres niveaux. Dans l'exemple illustré, le niveau intermédiaire est considéré comme le niveau binaire correspondant à l'état bloqué du circuit de type OR.

Dans l'exemple décrit, les circuits 11a et 11b sont faits de deux portes de type AND recevant respectivement les deux entrées. On a vu que d'autres circuits connus peuvent être employés pour obtenir la fonction désirée de l'un et/ou de l'autre circuit.

Dans le cas général comme dans l'exemple décrit, chacun des circuits peut comprendre deux amplificateurs différentiels partageant les mêmes résistances de charge R. Dans l'exemple décrit, le niveau intermédiaire se définit lorsque, chaque transistor conducteur tirant un courant de référence I/2, un courant I/2 passe dans chaque résistance de charge. Cependant, cette définition est un exemple rendu possible parce que dans la logique SCFL comme en ECL employées à titre d'exemple les transistors ont leurs sources communes, de sorte que le niveau intermédiaire peut être défini différemment dans d'autres contextes. Dans les conditions de l'exemple illustré, il s'ensuit que si les courants de référence I/2 s'additionnent dans une même résistance de charge, la sortie est au niveau logique 0 et la sortie complémentaire est au niveau 1.

La mise en oeuvre de cette définition a été faite dans l'exemple illustré en logique SCFL en connectant les diodes de blocage D' en parallèle sur les résistances de charge respectives R des amplificateurs Ta et Tb. De préférence, les diodes D' imposent une chute de tension suffisante pour réduire l'écart entre le niveau intermédiaire et l'un des deux autres niveaux à une valeur comprise dans la marge tolérable de bruit. La valeur de chute de tension peut être déterminée par le dimensionnement des diodes D'. Celle mise en oeuvre a l'avantage d'être simple dans l'exemple illustré et il est clair que d'autres modes de mise en oeuvre sont possibles et peuvent mieux convenir dans d'autres contextes. Dans l'exemple de la figure 4 de réalisation bipolaire, on a vu qu'il suffisait par exemple de dimensionner les transistors de façon suffisante pour pouvoir confondre en pratique les niveaux bas et intermédiaires. De même, bien que dans l'exemple illustré le niveau intermédiaire est considéré comme l'un des niveaux binaires quand l'écart entre les deux niveaux est compris dans la marge tolérable de bruit, d'autres moyens peuvent être employés pour les faire correspondre.

Quand les portes XOR et NXOR sont accouplées de la manière illustrée, on a vu qu'un exemple de réalisation des deux portes de type OR 13 consiste à les incorporer dans deux branches connectées à une source de courant constant et comportant chacune deux transistors en parallèle, les quatre transistors recevant respectivement les quatre impliquants. Bien sûr, d'autres portes de type OR peuvent convenir.

Dans l'exemple illustré, les transistors T (Ta, Tb, Tk, Tl, Tk', Tl', T) sont du type à déplétion et les transistors S sont du type à enrichissement. Cependant, les types pourraient être inversés, ou bien l'ensemble des transistors pourrait être de l'un des deux types.

## Revendications

1. Porte logique de type OU-Exclusif (10a, 10b) à deux entrées binaires a, b, caractérisée en ce qu'elle comprend un circuit (11a, 11b) à trois niveaux logiques pour la formation des impliquants premiers (K, L ; K', L') d'une fonction de type OU-Exclusif et un circuit de type OR (12a, 12b) pour faire la somme logique des impliquants premiers en considérant le niveau intermédiaire comme l'un des deux autres niveaux.

2. Porte selon la revendication 1, caractérisée en ce que le circuit est fait de deux portes de type AND recevant respectivement les deux entrées.

3. Porte selon la revendication 1 ou 2, caractérisée en ce que le circuit comprend deux amplificateurs différentiels (Ta, Tb) partageant les mêmes résistances de charge (R), et en ce que le niveau intermédiaire est formé par la conduction d'un courant (I/2) dans chacune des résistances de charge.

4. Porte selon la revendication 3, caractérisée en ce que la détermination des niveaux logiques est faite en connectant une diode de blocage en parallèle avec chacune des résistances de charge afin d'imposer une chute de tension suffisante pour considérer le niveau intermédiaire comme l'un des niveaux binaires.

5. Porte selon l'une des revendications 1 à 4, caractérisée en ce que le niveau intermédiaire est considéré comme l'un des niveaux binaires quand l'écart entre les deux niveaux est compris dans la marge tolérable de bruit.

6. Porte selon l'une des revendications 1 à 5, caractérisée en ce qu'elle est faite de transistors à base de semi-conducteur de type III-V, tel que l'arséniure de gallium.

7. Porte selon la revendication 6, caractérisée en ce qu'elle est faite en logique SCFL.

8. Porte selon la revendication 7, caractérisée en ce que les transistors sont de type MESFET.

9. Porte selon l'une des revendications 1 à 6, caractérisée en ce qu'elle est faite de transistors bipolaires.

10. Circuit intégré comprenant une porte de type OU-Exclusif, caractérisé en ce que la porte est celle définie par l'une des revendications précédentes.
